# EUROPÄISCHE PATENTANMELDUNG

(11) **EP 1 890 084 A2**
(43) Veröffentlichungstag der Anmeldung: **20.02.2008**
(21) Anmeldenummer: 07013900.1
(22) Anmeldetag: 16.07.2007
(51) Int. Cl.: F24C 3/12, H03K 17/96

(54) **Kochfeld**

(30) Priorität: 17.08.2006 DE 102006038414
(71) Anmelder: BSH Bosch und Siemens Hausgeräte GmbH, 81739 München (DE)
(72) Erfinder: Wilsdorf, Gerd, 82140 Olching (DE)

(57) **Zusammenfassung**

Die Erfindung betrifft. Ein Kochfeld (12; 312; 512), insbesondere für den Haushalt, mit einer Herdplatte (16), z.B. aus Glaskeramik, die eine beheizbare Kochzone (28) und eine Einstellzone (Abdeckung 30; 330; 530; 630) aufweist, wobei der Einstellzone mindestens ein Sensorschalter (26) zugeordnet ist, der auf Berührungen der Herdplatte oder Annäherungen z.B. von Fingern an die Herdplatte anspricht.

Um dabei Nachteile des bekannten Standes der Technik zu vermeiden oder zu vermindern und insbesondere die Bedienungsfreundlichkeit zu erhöhen und eine bessere Benutzerführung zu erzielen wird vorgeschlagen, eine auf der Herdplatte (16) angeordnete die Einstellzone übergreifende Abdeckung (30; 330; 530; 630) vorzusehen, die über der Einstellzone ein Fenster (40 bis 46; 340, 346) aufweist, durch das hindurch der Sensorschalter (26) betätigbar ist. Vorzugsweise weist dabei die Abdeckung (30; 330; 530; 630) im wesentlichen ein metallisches Material z.B. Edelstahl oder Aluminium auf, in dem das Fenster (40 bis 46; 340, 346) ausgebildet ist. Die Abdeckung (30; 330; 530; 630) kann auch einen Kantenschutz für die Herdplatte (16), z.B. aus Glaskeramik bilden.

## Beschreibung

Die Erfindung betrifft ein Kochfeld, gemäß dem Oberbegriff des Anspruches 1, insbesondere für den Haushalt.

Bei bekannten Kochfeldern dieser Art sind auf einer dunklen Glaskeramik-Herdplatte Kochzonen, Bedien- Bzw. Einstell- und Anzeigezonen durch Bedruckung markiert, wobei diese Markierungen nicht sehr kontrastreich hervortreten und daher etwas unübersichtlich sind. Der Benutzer muß also die Stellen auf der Herdplatte, die er zur Bedienung berühren muß, etwas suchen. Ferner dient die Herdplatte als Rangierfeld für Töpfe und wird auch häufig als Ablagefläche benutzt. Dadurch besteht die Gefahr einer unbeabsichtigten Betätigung der Einstelleinrichtungen z.B. durch Töpfe, Geschirr, Besteck, Putzlappen oder andere Gegenstände.

Aus der Deutschen Auslegeschrift DE 42 07 772 sind Sensorschalter zur Anordnung unter Glaskeramikkochfeldern bekannt, die die Gefahr einer unbeabsichtigten Betätigung durch Töpfe, andere Gegenstände oder beim Putzen verringern indem sie die Betätigung blockieren, wenn der Gegenstand eine gewisse Größe überschreitet und mehrere Sensoren gleichzeitig zum Ansprechen bringt. Dabei ist jeweils eine Infrarot-Lichtquelle mit mehren Sensoren und einer Schaltung zur Informationsauswertung kombiniert. Die Verwendung solcher Schalter, hat den Nachteil eines erhöhten Fertigungsaufwandes. Die Unübersichtlichkeit der Einstellzone wird dadurch nicht gemindert.

Der Erfindung liegt die Aufgabe zugrunde Nachteile des bekannten Standes der Technik zu vermeiden oder zu mindern und insbesondere die Bedienungsfreundlichkeit zu erhöhen.

Diese Aufgabe wird gelöst durch die Merkmalskombination des Anspruches 1.

Diese Lösung hat den Vorteil dass sie die Bedienbarkeit des Kochfeldes durch optische und eventuell auch haptische Führung des Benutzers leichter und schneller find- und verstehbar und damit auch sicherer macht. Die Bedienung wird eindeutiger und bequemer. Die Abdeckung bildet ferner eine Schwelle, die das Rangierfeld auf der Herdplatte begrenzt und auf einfache Weise die Gefahr einer versehentlichen Betätigung mittels eines Topfes mindert. Die Abdeckung, die vorzugsweise metallisch hell ist, kann leicht mit sehr gut lesbaren, eventuell auch räumlichen, z.B.geprägten Zeichen z. B. auch in Blindenschrift zur Kennzeichnung der Einstellmöglichkeiten versehen sein. Ferner bietet sich diese Lösung auch zur einfachen Produktdifferenzierung an. In größerer Stückzahl gefertigte Kochfelder können zum einen als Standardversion ohne Abdeckung verkauft werden und zum anderen als höherwertiges Produkt mit der Abdeckung. Zum Vertrieb unter verschiedenen Marken können auch unterschiedlich gestaltete Abdeckungen in Verbindung mit im übrigen gleichen Kochfeldern verwendet werden.

Insbesondere wenn das Kochfeld dazu eingerichtet ist eine Küchenarbeitsplatte, in die es einbaubar ist mit der Herdplatte zu übergreifen, wird gemäß einer bevorzugten Ausführungsform die Abdeckung in einem Randbereich der Herdplatte angeordnet und endet als Kantenschutz im Bereich der benachbarten Randkante, vorzugsweise der Vorderkante der Herdplatte. Dabei kann sie auf der Herdplatte nahe deren Randkante oder an der Randkante enden oder ein Stück darüber hinaus reichen und auch vor der Seitenfläche der Randkante nach unten geführt sein oder diese umgreifen. Dies gilt aber auch für von unten her mehr oder weniger hoch eingebettete, aber nach oben überstehende Randkanten der Herdplatte. Auch hierdurch wird ohne zusätzlichen Aufwand die Bedienungsfreundlichkeit weiter erhöht, da der Benutzer weniger aufpassen muß die Kante nicht z.B. mit einem Topf zu beschädigen. Ferner werden unterschiedliche, klare, gute Formgestaltungen möglich.

Das Fenster kann mit einem Material verschlossen sein, das den Sensorschalter aktivierende Signale durchlässt. Hierdurch werden Verschmutzungen des Fensters bzw. der Fenster verhindert und die Abdeckung kann eine ebene, leicht zu reinigende geschlossene Oberfläche aufweisen. Als Verschlußmaterial dient vorzugsweise ein Kunststoffmaterial, z.B. im Fall eines Sensorschalters mit einer Infrarotlichtquelle ein transparentes Kunststoffmaterial.

Alternativ kann das Fenster jedoch auch eine offene Durchbrechung der Abdeckung sein. Diese Ausführungsform hat den Vorzug preiswerter zu sein und wenn die Durchbrechung mindestens fingerbreit ist, den Betätigungsfinger des Benutzers zu führen, was die Bedienungsfreundlichkeit weiter erhöht. Unter Umständen kann in diesem Fall auch ein preiswerterer Sensorschalter verwendet werden als bei einem verschlossenen Fenster, da der Betätigungsfinger auf die Oberfläche der Herdplatte greifen kann und dem Sensorschalter näher kommt. Diese Ausführungsform ermöglicht auch einen anderen Sensorschalter z.B. einen kapazitiven Schalter mit einem z.B. durch Drucken auf die Herdplatte aufgebrachten Kondensatorfläche, das zur Betätigung berührbar ist.

Die Abdeckung kann aus einem Edelstahl- oder Aluminiumblech hergestellt sein. Der Verschluß des Fensters bzw. der Fenster kann durch Einspritzen eines Kunststoffmaterials oder durch Eindrücken eines vorgefertigten Kunststoffelementes hergestellt werden. Die metallische, helle Oberfläche der Abdeckung hat auch den Vorteil, dass darauf angebrachte Zeichen zur Kennzeichnung der Einstellmöglichkeiten besser lesbar sind als auf einer dunklen Herdplatte. Auch sind Abdeckungen mit Prägungen, z.B. zum Schutz darin eingedruckter Zeichen oder in Blindenschrift preiswert herstellbar.Das Fenster kann als Zeichen oder Teil eines Zeichens, z.B. als Pluszeichen oder Minuszeichen, ausgebildet sein, was gestalterisch elegante, schöne Lösungen ermöglicht.

Gemäß einer weiteren vorteilhaften Ausführungsform kann die Abdeckung zur Reinigung abnehmbar mittels lösbarer Befestigungsmittel am Kochfeld oder an einer Küchenarbeitsplatte, in die das Kochfeld einbaubar ist, gehalten werden. Hierdurch kann einerseits das Kochfeld leicht geputzt werden und andererseits die Abdeckung einfach im Spülbecken oder im Geschirrspüler gereinigt werden. Die Abdeckung kann dabei an der Seitenfläche der Randkante vorbei und vorzugsweise in einem Abstand von dieser nach unten geführt sein und auf oder nahe der Küchenarbeitsplatte enden und eventuell eine mit der Küchenarbeitsplatte zusammenwirkende Dichtung tragen. Wenn beim Zwischendurchreinigen der Arbeitsplatte Verschmutzungen auf dieser unter den Rand der Abdeckung geschoben werden, bleiben sie dort liegen und werden nicht unter den Rand des Kochfeldes, mit dem dieses sich auf der Küchenarbeitsplatte abstützt geschoben. Wenn zu einer gründlicheren Reinigung die Abdeckung weggenommen wird, lassen sich diese dann vor bzw. neben dem übrigen Kochfeld liegenden Verschmutzungen leicht entfernen, wodurch die Bedienungsfreundlichkeit weiter erhöht wird. Da der nach unten geführte Randbereich der Abdeckung die Randkante des übrigen Kochfeldes z.B. die Randkante der Herdplatte verdeckt, stört es nicht, wenn eine zwischen der Auflagefläche bzw. dem Randflansch des übrigen Kochfeldes und der Küchenarbeitsplatte angeordnete Dichtung direkt bis an die Randkante heranreicht oder sogar bis vor diese reicht, was die Bedienungs- bzw. Reinigungsfreundlichkeit nochmals erhöht.

Die Befestigungsmittel können mindestens einen Magneten aufweisen, der z.B. durch die Herdplatte hindurch auf die Abdeckung einwirken kann, die einen magnetisierbaren z.B. ferritischen Edelstahl aufweisen kann oder ein zusätzliches magnetisierbares Element oder einen Magneten aufweist. Mindestens Teile der Befestigungsmittel können neben der Herdplatte bzw neben dem Rand des übrigen Kochfeldes am übrigen Kochfeld angeordnet oder an der Küchenarbeitsplatte befestigbar sein und von der Abdeckung verdeckt werden. Der Abstand zwischen dem nach unten geführten Randbereich der Abdeckung und der Randkante des übrigen Kochfeldes kann somit zur unsichtbaren Unterbringung von Befestigungsmitteln, z.B. in Form von Magneten oder Federklammern genutzt sein, die auch die alleinige Haltung der Abdeckung übernehmen können.

Die Abdeckung kann ferner z.B. parallel zur Randkante verschiebbar geführt sein zwischen einer Arbeitsstellung und einer Sicherungsstellung, in der sie das Kochfeld abschaltet oder Änderungen der Einstellungen verhindert. Die Abdeckung kann dabei in der Sicherungsstellung mehrere Sensorschalter gleichzeitig aktivieren, was durch eine Auswertschaltung erkannt wird und zur Abschaltung des Kochfeldes führt. Alternativ kann die Abdeckung den oder die Sensorschalter in der Sicherungsstellung so abdecken, dass der Benutzer den Sensorschalter nicht mehr aktivieren kann, wobei die Unterseite der Abdeckung so gestaltet ist, dass sie den Sensorschalter nicht betätigt. Die Abdeckung kann auch so ausgestaltet sein, dass sie in der Sicherungsstellung jede Veränderung der vorgenommenen Einstellungen z.B. der Heizleistung verhindert, jedoch eine Ausschaltung des Kochfeldes jederzeit zulässt. Die Abdeckung kann auch mit einem Schalter, z.B. einem unter der Herdplatte angeordneten Magnetschalter zusammenwirken, der bei abgenommener Abdeckung anspricht und eine Sicherheitsmaßnahme ergreift, z.B. eine Unterbrechung der Stromversorgung der Kochzonen bewirkt, wodurch die Sicherheit gegen versehentliche Einstellungen beim Putzen des Gerätes erhöht wird.

Im folgenden wird die Erfindung anhand schematischer Zeichnungen an Ausführungsbeispielen näher erläutert.

Es zeigt
- Fig.1: eine Draufsicht auf den vorderen Teil eines Kochfeldes mit zwei Kochzonen in Verbindung mit einer Küchen-Arbeitsplatte, in die es eingesetzt ist;
- Fig.2: in einem vergrößerten Maßstab, ausschnittsweise einen Schnitt im wesentlichen entlang der Linie II-II in Fig.1; .
- Fig.3: eine Draufsicht auf den vorderen Teil eines Kochfeldes gemäß einer abgewandelten Ausführungsform;
- Fig.4: in vergrößerter Darstellung, ausschnittsweise einen Schnitt im wesentlichen entlang der Linie IV-IV in Fig.3;
- Fig.5: in einem Schnitt entsprechend dem der Figuren 2 und 4 ausschnittsweise eine weitere abgewandelte Ausführungsform und
- Fig.6: ausschnittsweise eine Draufsicht auf eine abgewandelte Abdeckung.

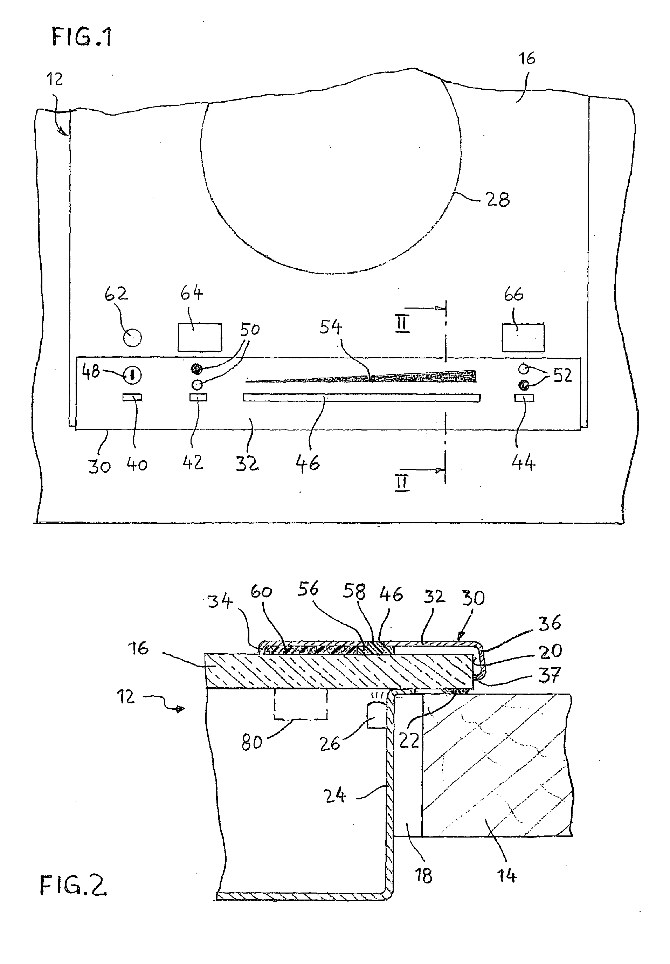

Ein in den Figuren 1 und 2 in eine Küchenarbeitsplatte 14 eingebaut dargestelltes Kochfeld 12 besitzt deckseitig eine Herdplatte 16 aus Glaskeramik, die einen Einbauausschnitt 18 der Küchenarbeitsplatte 14 rundum übergreift. Die Herdplatte 16 besitzt eine umlaufende vertikale Randkante 20 und an ihrer Unterseite in einem kleinen Abstand davon eine Dichtung 22, mit der das Kochfeld 12 sich auf der Küchenarbeitsplatte 14 abstützt. Im Ausschnitt 18 der Küchenarbeitsplatte 14 ist in einem größeren Abstand von der Randkante 20 eine aus Stahlblech gezogene Wanne 24 an der Unterseite der Herdplatte 16 befestigt, die nicht dargestellte Heizeinrichtungen und elektrische Anschlüsse aufweist. In der Wanne 24 sind parallel zur vorderen Randkante 20 eine Reihe von Sensorschaltern 26 angeordnet, von denen nur einer in Fig. 2 zu sehen ist. Diese bestehen jeweils aus einer nach oben gegen die Unterseite der Herdplatte,16 hin strahlenden Infrarot-Lichtquelle und mindestens einem benachbarten Sensor für reflektiertes Licht. Die Herdplatte besitzt zwei hintereinander liegende Kochzonen, von denen nur die vordere Kochzone 28 in Fig.1 zu sehen ist.

Der vorderste Bereich der Herdplatte 16 wird von einer Abdeckung 30 aus Edelstahlblech übergriffen, die eine zur Oberfläche der Herdplatte 16 parallele Deckwand 32 besitzt und an ihrer Hinterkante und an ihren Seitenkanten etwa um die Blechstärke nach unten auf die Herdplatte 16 abgewinkelte Randabschnitte 34. Nach vorn übergreift die Abdeckung 30 die Herdplatte 16 ein Stück und besitzt einen, ein kleines Stück vor der Randkante 20 derselben nach unten greifenden Frontwandabschnitt 36, der an seinem unteren Ende im unteren Drittel der Randkante 20 in einen gegen diese hin abgewinkelten und an dieser anliegenden Randabschnitt 37 übergeht. Die Abdeckung 30, die die Randkante 20 der Herdplatte 16 aus Glaskeramik frontseitig übergreift und rechts und links auf der Oberfläche der Herdplatte 16 bis nahe an die Randkante hinreicht, dient einerseits als Kantenschutz für die Herdplatte 16 aus Glaskeramik und bildet im übrigen die Einstellzone des Kochfeldes 12. In ihrer Deckwand 32 sind in einer Reihe parallel zur Frontseite der Randkante 20 über den Sensorschaltern 26 mehrere Fenster in Form von Durchbrechungen ausgebildet unter denen die Sensorschalter 26 angeordnet sind. Dabei handelt es sich im einzelnen um ein Ein-Aus-Schalt-Fenster 40, zwei KochzonenWahlfenster 42 und 44 und ein dazwischen angeordnetes langes HeizleistungswahlFenster 46, hinter dem eine Reihe von Sensorschaltern 26 zur Bildung eines so genannten Touch-Sliders, eine Art berührungslosen Schiebeschalters, angeordnet ist. Neben den Fenstern, nach hinten sind entsprechende Symbole bzw. Zeichen 48 bis 54 als Bedienungshinweise auf die Deckwand 32 aufgedruckt. Zwischen der Deckwand 32 und der Herdplatte 16 liegt ein Verschlußstreifen 56 aus einem für Infrarotlicht transparenten Kunststoff und besitzt nach oben gerichtete Verschlußansätze 58, die genau in die Fenster 40 bis 46 passen und diese Ausfüllen und verschließen, wobei ihre Oberfläche bündig mit der Oberfläche der Deckwand 32 ist, um das Festsetzen von Verschmutzungen zu verhindern. Zwischen dem Verschlußstreifen 56 und dem nach unten abgewinkelten hinteren Randabschnitt 34 der Abdeckung 30 ist eine Klebstoffschicht 60 angeordnet, mit der die Abdeckung 30 auf die Herdplatte 16 geklebt ist. Alternativ kann die Abdeckung auch magnetisierbar sein und mittels unter der Herdplatte angeordneter, durch unterbrochene Linien angedeuteter Permanentmagnete 80 lösbar gehalten sein. Anstelle der Klebstoffschicht 60 wäre dann eine Dichtung einzusetzen.

Unmittelbar hinter der Abdeckung 30 besitzt die Herdplatte 16 eine Anzeigezone in der unter ihr angeordnete Leuchtanzeigen durch sie hindurch sichtbar sind. Im einzelnen handelt es sich um eine Ein-Aus-Anzeige 62 und zwei Leistungsanzeigen 64 und 66 mit nicht dargestellten sieben Segment-Leuchtanzeigen für die beiden Kochzonen.

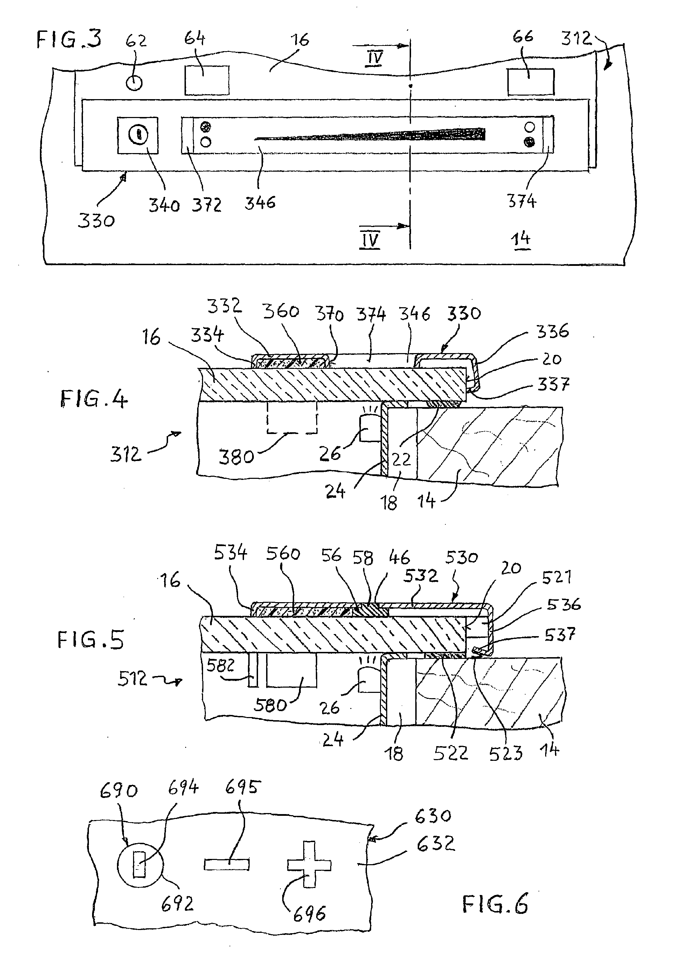

Ein abgewandeltes Kochfeld 312 gemäß den Figuren 3 und 4 zeigt eine abgewandelte Abdeckung 330 in Verbindung mit dem im übrigen unveränderten Kochfeld gemäß den Figuren 1 und 2, wobei gleiche Teile mit den gleichen Bezugsziffern bezeichnet sind. Die Abdeckung 330 besitzt eine sich über der Herdplatte 16 und parallel zu dieser erstreckende Deckwand 332 und hinten und seitlich nach unten abgewinkelte Randabschnitte 334 sowie einen nach unten abgewinkelten Frontwandabschnitt 336 und ein Endabschnitt 337, die mit den Randabschnitten 34, 36 und 37 übereinstimmen. Anstelle der kleinen verschlossenen Fenster der ersten Ausführungsform besitzt diese Ausführungsform zwei größere Fenster, deren Abmessungen so gewählt sind, dass der Finger eines Benutzers durch das Fenster hindurch direkt auf die Oberseite der Herdplatte greifen kann, um die darunter angeordneten Sensorschalter 26 zu betätigen. Dabei handelt es sich im einzelnen um ein Ein-Aus-Schaltfenster 340 und ein längliches zweites Fenster 346 unter dem die Sensorschalter sowohl für die Kochzonenwahl als auch für die Heizleistungseinstellung liegen. Entsprechende als Bedienungshinweise dienende Zeichen sind so auf die Oberseite der Herdplatte 16 gedruckt, dass sie durch die Fenster sichtbar sind, aber die Betätigung der Sensorschalter nicht behindern. Diese Bedruckung kann auch bei der Ausführungsform der Figuren 1 bis 2 vorhanden sein, so dass Kochfelder aus einer Produktion wahlweise mit den beiden verschiedenen Abdeckung oder ohne Abdeckung als einfachere preiswertere Ausführungsform vertrieben werden können. Die Ränder der beiden Fenster 320 und 346 besitzen nach unten bis auf die Oberfläche der Herdplatte 16 führende abgewinkelte Randabschnitte 370, wobei Randabschnitte 372 und 374 am rechten und linken Ende des langen Fensters 346 schräg nach außen oben verlaufen können, um dem Finger des Benutzers eine angenehme Führung zu geben. Abweichend von der dargestellten Ausführungsform könnte mindestens auch die rechte Kante des Ein-Aus-Schalt-Fensters 340 als schräge Rampe geformt sein. Die Ausführungsform gemäß den Figuren 3 und 4 gibt dem Benutzer eine noch bessere Führung als die Ausführungsform gemäß den Figuren 1 und 2, ist jedoch etwas anfälliger für Verschmutzungen aufgrund der offenen Fenster. Zwischen den Fenstern 340 und 346 und den Randabschnitten 334 ist die Abdeckung 330 mittels einer Klebstoffschicht 360 auf die Herdplatte 16 geklebt. Auch hier kann alternativ mittels eines unter der Herdplatte 16 angeordneten Permanentmagneten 380 die Abdeckung zur Reinigung lösbar gehalten und die Klebstoffschicht durch eine weiche Dichtung ersetzt sein.

Fig. 5 zeigt ein weiteres abgewandeltes Kochfeld 512, wobei wiederum mit der Ausführungsform gemäß den Figuren 1 und 2 übereinstimmende Teile mit den gleichen Bezugsziffern wie dort bezeichnet sind. Eine frontseitige, die Einstellzone übergreifende Abdeckung 530 besitzt eine Deckwand 532, die sich parallel zur Deckseite der Herdplatte 16 und in einem kleinen Abstand über dieser erstreckt. Darin sind die gleichen Fenster 40 bis 46 wie bei der ersten Ausführungsform als Durchbrechungen ausgebildet und durch einen Verschlußstreifen 56 mit Verschlußansätzen 58 verschlossen. Dahinter bis zu einem nach unten abgewinkelten Endabschnitt 534 und zu nicht dargestellten seitlichen nach unten abgewinkelten Randabschnitten ist eine elastische Dichtung 560 in die Abdeckung 530 eingeklebt, die verhindert, dass Verschmutzungen z.B. durch übergelaufenes Kochgut unter die Abdeckung 530 fließt und eventuell die Sensorschalter 26 in ihrer Funktion behindert. Die Abdeckung 530 besteht hauptsächlich aus einem ferritischen, magnetisierbaren Edelstahlblech und wird durch einen in der Wanne 24 an der Unterseite der Herdplatte 16 angeordneten Permanentmagneten 580, zur Reinigung lösbar, auf der Herdplatte 16 festgehalten. Dabei wird die Dichtung 560, die an ihrer Unterseite z.B. gerippt sein kann oder alternativ eine Lippendichtung ist, elastisch an die Herdplatte 16 angedrückt. Bei abgenommener Abdeckung 530 ändert sich das Streufeld des Magneten 580 und betätigt einen daneben angeordneten Magnetschalter 582, der die Stromversorgung der Kochzonen unterbricht bzw. eine Ausschaltung des Kochfeldes bewirkt. Auf diesen Magnetschalter 582 kann alternativ auch verzichtet werden. Dann ist das Kochfeld bei abgenommener Abdeckung 530 nach wie vor normal bedienbar, wozu auf die Herdplatte in der Einstellzone geeignete Markierungen aufgedruckt sind.

Im vordersten Bereich ragt die Abdeckung 530 ein Stück über die vordere Randkante 520 der Herdplatte 16 hinaus und besitzt einen vertikal nach unten abgewinkelten Frontwandabschnitt 536, der bis nahe an die Küchenarbeitsplatte 14 heranreicht und in einen schräg nach hinten oben abgewinkelten Endabschnitt 537 übergeht. Dieser trägt an seiner Unterseite eine mit der Küchenarbeitsplatte 14 zusammenwirkende elastische Lippendichtung 523. Mit der vorderen Randkante 20 der Herdplatte 16 sind zwei Permanentmagnete 521 durch Kleben verbunden, an denen die Rückseite des Frontwandabschnittes 536 anliegt und in einer definierten Lage relativ zur Herdplatte 16 zur Reinigung lösbar festgehalten wird. Eine zwischen der Herdplatte 16 und der Küchenarbeitsplatte 14 angeordnete Dichtung 522 ist bis zur Randkante 20 vorgezogen, da sie durch die bis zur Arbeitsplatte 14 reichenden Abdeckung 530 der Sicht entzogen ist. Diese Ausführungsform ist besonders reinigungsfreundlich. Bei schnellen Zwischendurchreinigungen unter die Abdeckung 530 geschobene Verschmutzungen wie z.B. Krümel sammeln sich unter dem vorderen Endabschnitt 537 und liegen bei abgenommener Abdeckung 530 leicht entfernbar vor der Herdplatte 16, wobei die Reinigungsfreundlichkeit dadurch weiter erhöht ist, dass deren Dichtung 522 bis in den Sichtbereich an der Randkante 520 vorgezogen ist und keine Schmutzfuge bleibt. An Stelle der Permanentmagnete 521 können auch Federlamellen vorgesehen sein, die außen an der Wanne 24 befestigt sind, unter der Dichtung 522 hindurch greifen und mit dem vorderen Endabschnitt 537 der Abdeckung 530 zusammenwirken.

An der Rückseite des Frontwandabschnittes 536 können Anschläge befestigt sein, die mit den an die Randkante 520 der Herdplatte geklebten Permanentmagnete zusammenwirken und eine kleine Verschiebung der Abdeckung 530 nach rechts und links auf der Herdplatte 16 zulassen. Dies kann dazu genutzt werden, die Abdeckung 530 zu verschieben zwischen einer Betriebsstellung und einer Sicherungsstellung, in der das Kochfeld ganz ausgeschaltet ist. Z.B. können in der Sicherungsstellung die Fenster 40 bis 46 so verschoben sein, dass die Abdeckung mehrere Sensorschalter 26 zum Ansprechen bringt und eine nachgeschaltete Auswertschaltung daraufhin das Kochfeld ausschaltet oder Verstellungen der eingestellten Werte blockiert. Das lange Heizleistungseinstellfenster 46 kann in eine Reihe einzelner, jeweils den Sensorschaltern 26 zugeordneter Fenster aufgeteilt sein. Eventuell kann auch die Unterseite der Abdeckung so gestaltet sein, dass sie die Sensorschalter 26 nicht zum Ansprechen bringt, aber die Fenster so verschoben werden, dass sie nicht mehr mit den Sensorschaltern 26 in Übereinstimmung sind und die Bedienung blockiert ist.

Fig.6 zeigt eine abgewandelte Abdeckung 630 mit einer Deckwand 632, in der Fenster in Form von Zeichen bzw. Symbolen ausgebildet sind. Das Ein- bzw. Ausschaltzeichen 690 besitzt in einem Kreis 692 ein sich von vorn nach hinten erstreckendes schlitzförmiges Fenster 694. Daneben ist ein sich von rechts nach links erstreckendes schlitzförmiges Fenster 695 in Form eines Minuszeichens angeordnet und daneben ein Fenster 696 in Form eines Pluszeichens. Durch die Fenster sind Sensorschalter aktivierbar In diesem Fall wird abweichend von den vorhergehenden Ausführungsformen die Heizleistung nicht durch Verschiebung des Fingers über einer Reihe von Sensorschaltern eingestellt, sondern durch Takten oder längere Berührungan der so markierten Minus- oder Plus-Stelle.

### Bezugsziffern:

- 12: Kochfeld
- 14: Küchenarbeitsplatte
- 16: Herplatte
- 18: Ausschnitt
- 20: Randkante der Herdplatte
- 22: Dichtung
- 24: Wanne
- 26: Sensorschalter
- 28: Kochzone
- 30: Abdeckung
- 32: Deckwand
- 34: Randabschnitt
- 36: Frontwandabschnitt
- 37: Randabschnitt
- 40: Ein- und Ausschaltfenster
- 42: Kochzonenwahlfenster
- 44: Kochzonenwahlfenster
- 46: Heizleistungswahlfenster
- 48: Zeichen
- 50: Zeichen
- 52: Zeichen
- 54: Zeichen
- 56: Verschlußstreifen
- 58: Verschlußansätze
- 60: Klebstoffschicht
- 62: Ein- und Ausschaltanzeige
- 64: Leistungsanzeige
- 66: Leistungsanzeige
- 80: Permanentmagnete

- 330: Abdeckung
- 332: Deckwand
- 334: Randabschnitte
- 336: Frontwandabschnitt
- 340: Ein- und Ausschaltfenster
- 346: Fenster
- 370: Randabschnitt
- 372: Randabschnitt
- 374: Randabschnitt
- 380: Permanentmagnete

- 521: Permanentmagnete
- 522: Dichtung
- 523: Dichtung
- 530: Abdeckung
- 532: Deckwand
- 534: Endabschnitt
- 536: Frontwandabschnitt
- 537: Endabschnitt
- 560: Dichtung
- 580: Permanentmagnet
- 582: Magnetschalter

- 630: Abdeckung
- 632: Deckwand
- 690: Ein- und Ausschaltzeichen
- 692: Kreis
- 694: Fenster
- 695: Fenster
- 696: Fenster

## Patentansprüche

1. Kochfeld (12; 312; 512), insbesondere für den Haushalt, mit einer Herdplatte (16), z.B. aus Glaskeramik, die eine beheizbare Kochzone (28) und eine Einstellzone (Abdeckung 30; 330; 530; 630) aufweist, wobei der Einstellzone mindestens ein Sensorschalter (26) zugeordnet ist, der auf Berührungen der Herdplatte oder Annäherungen z.B. von Fingern an die Herdplatte anspricht, **gekennzeichnet durch** eine auf der Herdplatte (16) angeordnete, die Einstellzone übergreifende Abdeckung (30; 330; 530; 630), die über der Einstellzone ein Fenster (40 bis 46; 340, 346) aufweist, **durch** das hindurch der Sensorschalter (26) betätigbar ist.

2. Kochfeld nach Anspruch 1, **dadurch gekennzeichnet, dass** die Abdeckung (30; 330; 530; 630) im wesentlichen ein metallisches Material z.B. Edelstahl oder Aluminium aufweist und in diesem das Fenster (40 bis 46; 340, 346) ausgebildet ist.

3. Kochfeld nach Anspruch 1 oder 2, **dadurch gekennzeichnet, dass** die Abdeckung (30; 330; 530; 630) in einem Randbereich der Herdplatte (16) angeordnet ist und als Kantenschutz im Bereich der benachbarten Randkante (20) der Herdplatte (16) endet.

4. Kochfeld nach einem der Ansprüche 1 bis 3, **dadurch gekennzeichnet, dass** die Abdeckung vor die Seitenfläche (20) der Randkante (20) nach unten geführt ist.

5. Kochfeld nach einem der Ansprüche 1 bis 4, **dadurch gekennzeichnet, dass** es dazu eingerichtet ist eine Küchenarbeitsplatte (!4), in die es einbaubar ist, mit der Herdplatte (16) als Randflansch zu übergreifen.

6. Kochfeld nach einem der Ansprüche 1 bis 5, **dadurch gekennzeichnet, dass** das Fenster (40 bis 46) mit einem Material, verschlossen ist, das den Sensorschalter (26) aktivierende Signale durchlässt.

7. Kochfeld nach einem der Ansprüche 1 bis 5, **dadurch gekennzeichnet, dass** das Fenster (340, 346) eine offene Durchbrechung der Abdeckung (330) ist.

8. Kochfeld nach Anspruch 7, **dadurch gekennzeichnet, dass** die Durchbrechung (340, 346) mindestens fingerbreit ist.

9. Kochfeld nach einem der Ansprüche 1 bis 8, **dadurch gekennzeichnet, dass** die Abdeckung (30) Zeichen (48 bis 54) zur Kennzeichnung der Einstellmöglichkeiten aufweist.

10. Kochfeld nach Anspruch 9, **dadurch gekennzeichnet, dass** das Fenster als Zeichen (690, 695, 696) oder Teil eines Zeichens ausgebildet ist.

11. Kochfeld, insbesondere nach einem der Ansprüche 1 bis 10, insbesondere für den Haushalt, mit einem Randflansch (Herdplatte 16) zum Übergreifen des Randes eines Einbauausschnitts (18) einer Küchenarbeitsplatte (14) und zur Abstützung des Kochfeldes (12; 312, 512) auf der Küchenarbeitplatte (14), **gekennzeichnet durch** eine entlang mindestens einer Randkante (20) des Randflansches (Herdplatte (16) angeordnete Abdeckung (30; 330; 530), die mittels lösbarer Befestigungsmittel (Permanentmagnete 80; 380; 580, 521) zur Reinigung abnehmbar in ihrer Betriebslage gehalten ist.

12. Kochfeld nach Anspruch 11, **dadurch gekennzeichnet, dass** die Abdeckung (30; 330; 530) mittels mindestens eines Teils der lösbaren Befestigungsmittel (Permanentmagnete 80; 380; 580, 521) am übrigen Kochfeld oder an der Küchenarbeitsplatte befestigbar ist.

13. Kochfeld nach Anspruch 11 oder 12, **dadurch gekennzeichnet, dass** mindestens Teile (Permanentmagnete 521) der lösbaren Befestigungsmittel, von der Abdeckung (530) verdeckt, im Bereich neben der Randkante des übrigen Kochfeldes, z.B. der Randkante (20) der Herdplatte (16) angeordnet sind.

14. Kochfeld nach einem der Ansprüche 11 bis 13, **dadurch gekennzeichnet, dass** die Abdeckung sich neben der Randkante des übrigen Kochfeldes, z.B. der Randkante (20) der Herdplatte (16) und vorzugsweise in einem horizontalen Abstand von dieser nach unten, bis nahe an oder auf die Küchenarbeitsplatte (14) erstreckt.

15. Kochfeld nach einem der Ansprüche 11 bis 14, **dadurch gekennzeichnet, dass** die Abdeckung (530) eine Dichtung (523) zum Zusammenwirken mit der Küchenarbeitsplatte aufweist

16. Kochfeld nach einem der Ansprüche 11 bis 15, **dadurch gekennzeichnet, dass** die Abdeckung (530) eine Dichtung (560) zum Zusammenwirken mit dem übrigen Kochfeld, vorzugsweise dessen Deckseite aufweist.

17. Kochfeld nach einem der Ansprüche 11 bis 16, **dadurch gekennzeichnet, dass** die Befestigungsmittel mindestens einen Magneten (80; 380; 580, 521) aufweisen.

18. Kochfeld nach einem der Ansprüche 11 bis 17, **dadurch gekennzeichnet, dass** die Abdeckung (30; 330; 530) ein magnetisierbares Material aufweist.

19. Kochfeld nach einem der Ansprüche 1 bis 18, **dadurch gekennzeichnet, dass** die Abdeckung (530) verschiebbar geführt ist zwischen einer Arbeitsstellung und einer Sicherungsstellung.

20. Kochfeld nach einem der Ansprüche 11 bis 19, **dadurch gekennzeichnet**, durch einen auf die Anwesenheit der Abdeckung (530) ansprechenden Schalter, der auf die Steuerung der Kochzonen einwirkt, z.B. einen unter der Herdplatte angeordneten Magnetschalter (582).
